# EUROPÄISCHE PATENTANMELDUNG

(11) **EP 2 237 212 A1**
(43) Veröffentlichungstag der Anmeldung: **06.10.2010**
(21) Anmeldenummer: 09004911.5
(22) Anmeldetag: 02.04.2009
(51) Int. Cl.: G06Q 30/00, G06Q 50/00, G01R 22/00

(54) **Verfahren zur Aufschlüsselung des elektrischen Verbrauchs einer Mehrzahl von elektrischen Verbrauchsgeräten und Vorrichtung hierzu**

(71) Anmelder: Fraunhofer-Gesellschaft zur Förderung der angewandten Forschung e.V., 80686 München (DE)
(72) Erfinder: Büttner, Markus, Dr., 79110 Freiburg (DE)
(74) Vertreter: Pfenning, Meinig & Partner GbR

(57) **Zusammenfassung**

Die vorliegende Erfindung bezieht sich auf ein Verfahren zur Aufschlüsselung des elektrischen Verbrauchs einer Mehrzahl von elektrischen Verbrauchsgeräten, wobei mittels einer Messstelle der elektrische Gesamtverbrauch dieser Mehrzahl von Verbrauchsgeräten als Messwert-Zeitreihe (M) zeitaufgelöst erfasst wird, und wobei unter Verwendung dieser zeitaufgelöst erfassten Messwert-Zeitreihe jeweils mindestens ein elektrischer Verbrauchskennwert (V1, V2, ...) für mehrere unterschiedliche elektrische Verbrauchsklassen der Verbrauchsgeräte dieser Mehrzahl von Verbrauchsgeräten berechnet wird, bevorzugt computergestützt berechnet wird.

## Beschreibung

Die vorliegende Erfindung bezieht sich auf ein Verfahren zur Aufschlüsselung des elektrischen Verbrauchs einer Mehrzahl von elektrischen Verbrauchsgeräten und auf eine Vorrichtung, mit der ein solches Verfahren durchführbar ist.

Im Rahmen der vorliegenden Erfindung wird dabei unter dem allgemeinen Begriff des elektrischen Verbrauchs von elektrischen Geräten der elektrische Energieverbrauch, der elektrische Leistungsbedarf, der elektrische Stromverbrauch oder auch eine andere entsprechende Kenngröße verstanden, die ein Maß für die Umsetzung an Energie durch die entsprechenden Verbrauchsgeräte ist. Insbesondere kann die zur Aufschlüsselung des Verbrauchs der Geräte betrachtete elektrische Kenngröße von einer physikalischen Kenngröße abhängen oder mit der letzteren identisch sein, die eine im Rahmen der vorliegenden Erfindung verwendete Messstelle zur Erfassung des Verbrauchs liefert (so können z.B. als Basisinformationen der vorliegenden Erfindung die Messwerte eines Haushaltsstromzählers in Form von über definierte Zeitintervalle erfassten mittleren elektrischen Leistungen verwendet werden; es genügt dazu, die Zählerstände z.B. im 15-Minuten-Raster auszulesen).

Da eine mittlere Leistung P ohne weiteres über P = ΔW/Δt in einen mittleren Energieverbrauch ΔW pro Zeiteinheit Δt umgerechnet werden kann, werden beide Begriffe Leistung (in Watt) und Energieverbrauch (in Wattstunden) in der folgenden Beschreibung z. T. synonym verwendet.

Unter einem Mittelwert wird im Rahmen der vorliegenden Erfindung in der Regel das arithmetische Mittel verstanden, es kann jedoch auch das geometrische Mittel oder ein andersartig gemittelter Wert als Mittelwert verwendet werden.

Aus dem Stand der Technik sind bereits Last- bzw. Verbrauchserkennungsalgorithmen bekannt, die jedoch eine große Menge an Informationen benötigen: Dazu gehören Vormessungen (Messung der Lastgangskurven von Verbrauchern), vorab bekannte Informationen zum Gerätebestand des Verbrauchers und/oder hoch aufgelöste Messwerte für den Lastgang im Sekundenbereich.

Solche Algorithmen können zwar unter Umständen gute Ergebnisse liefern, sind aber aus praktischen Gründen zur Erzielung eines Mehrwertes für eine große Menge von Stromkunden kaum einsetzbar: Der Aufwand für entsprechende Vormessungen und den entsprechenden Informationsaustausch ist zu hoch, ebenso wie die zu übertragende Datenmenge.

Aufgabe der vorliegenden Erfindung ist es daher, ausgehend vom Stand der Technik ein Verfahren (und eine entsprechende Vorrichtung) zur Verfügung zu stellen, mit dem auf einfache und zuverlässige Art und Weise und mit einer möglichst geringen Anzahl von auszutauschenden Daten eine Aufschlüsselung des elektrischen Verbrauchs einer Mehrzahl von elektrischen Verbrauchsgeräten und eine Generierung entsprechender Informationen möglich ist.

Diese Aufgabe wird durch ein Verfahren gemäß Patentanspruch 1 sowie durch eine entsprechend ausgebildete Vorrichtung gemäß Patentanspruch 14 gelöst. Vorteilhafte Ausführungsformen des erfindungsgemäßen Verfahrens (bzw. der erfindungsgemäßen Vorrichtung) ergeben sich jeweils aus den abhängigen Ansprüchen.

Nachfolgend wird die vorliegende Erfindung anhand eines ausführlichen Ausführungsbeispiels beschrieben. Die im Rahmen der Schilderung des Ausführungsbeispiels vorgestellten Einzelmerkmale müssen im Rahmen der vorliegenden Erfindung nicht kumulativ (d.h. gemeinsam miteinander) realisiert werden, sondern können auch einzeln (d.h. unabhängig voneinander) in einem erfindungsgemäßen Verfahren bzw. in einer erfindungsgemäßen Vorrichtung verwirklicht sein.

Die grundlegende Idee der vorliegenden Erfindung basiert auf der Überlegung, das Energiesparen zu fördern und durch eine geeignete Rückmeldung des Stromverbrauchs z.B. an die einzelnen Verbraucher (beispielsweise die Haushalte) letzteren die Möglichkeit zu geben, den Stromverbrauch zu vergleichen und auch zu bewerten (Feedback-System).

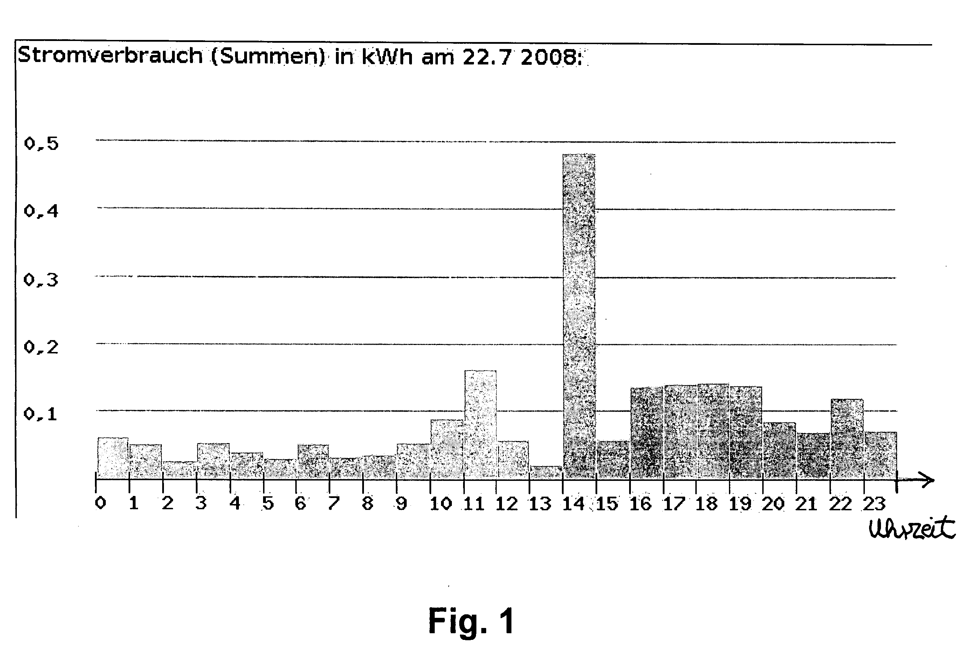

Ein sehr einfacher Fall der Umsetzung einer solchen Idee wäre das Zurverfügungstellen des Stromverbrauchs in Abhängigkeit von der Tageszeit (vgl. Figur 1). Um jedoch bewerten zu können, durch welche Geräte der Strom im einzelnen verbraucht wird, werden erfindungsgemäß aus solchen Messwerten zusätzliche Informationen berechnet. Dies wird dazu verwendet abzuschätzen, welche einzelnen Verbrauchsgeräte oder welche Klassen von Verbrauchsgeräten wieviel Energie verbrauchen.

Erfindungsgemäß ermittelt dazu das Verfahren zur Aufschlüsselung des elektrischen Verbrauchs einer Mehrzahl von elektrischen Verbrauchsgeräten (beispielsweise aller Geräte in einem definierten Haushalt) mittels einer Messstelle den elektrischen Gesamtverbrauch der Mehrzahl von Verbrauchsgeräten in einer zeitaufgelösten Messwert-Zeitreihe, also in einer Vielzahl von aufeinanderfolgenden Einzelmessungen des elektrischen Gesamtverbrauchs. Unter Verwendung dieser zeitaufgelöst erfassten Messwert-Zeitreihe wird dann jeweils für verschiedene elektrische Verbrauchsklassen der erfassten Verbrauchsgeräte ein elektrischer Verbrauchskennwert berechnet, wobei zu dieser Berechnung bevorzugt ein Mikroprozessor und/oder Rechnersystem eingesetzt wird.

Vorteilhafterweise erfolgt die Berechnung der mehreren elektrischen Verbrauchskennwerte (der Geräteklassen) ausschließlich unter Verwendung der zeitaufgelöst erfassten Messwert-Zeitreihe, d.h. andere Daten und/oder Informationen als die von der entsprechenden Messstelle erfasste Messwert-Zeitreihe werden nicht benötigt. Bei der Messstelle, die die einzelnen Messwerte der Messwert-Zeitreihe erfasst, kann es sich vorteilhafterweise um einen Stromzähler handeln, bei den einzelnen Messwerten um den über ein Zeitintervall (beispielsweise der Länge von 10 bis 15 min.) zeitlich gemittelten Energie- oder Stromverbrauch.

Das erfindungsgemäße Verfahren kommt somit ohne besondere Informationen aus und kann, wie nachfolgend noch im Detail beschrieben, dennoch eine hinreichend genaue Verbrauchsabschätzung liefern.

Erfindungsgemäß wird vorteilhafterweise der Energieverbrauch für vier Verbraucherklassen (bzw. für vier Geräteklassen) berechnet:
1. Für aktive Standby-Geräte, die permanent Energie verbrauchen (z.B. Stereoanlagen, Internetverbindungen per DSL...). Der so ermittelte Verbrauchskennwert wird nachfolgend auch als erster elektrischer Verbrauchskennwert V1 bezeichnet.
2. Für regelmäßige zyklische Verbraucher, also Verbraucher, die sich selbständig zu bestimmten Zeitpunkten einschalten und dann auch selbständig nach einer vorbestimmten Zeitspanne wieder ausschalten (beispielsweise Kühlschrank, Tiefkühltruhe etc.). Der entsprechende Verbrauchskennwert wird nachfolgend auch als zweiter elektrischer Verbrauchskennwert V2 bezeichnet.
3. Für temporär aktive Großverbraucher, also Verbrauchsgeräte, die typischerweise von einem Benutzer eingeschaltet und wieder ausgeschaltet werden (beispielsweise Herd, Spülmaschine, Waschmaschine etc.). Der entsprechende Verbrauchskennwert wird nachfolgend auch als dritter elektrischer Verbrauchskennwert V3 bezeichnet.
4. Den im Rahmen des vorbeschriebenen, durch den erster bis dritter Verbrauchskennwert V1 bis V3 noch nicht erfassten Verbrauchsgeräten bzw. deren Verbrauch kann ein weiterer, vierter Verbrauchskennwert V4 zugewiesen werden.

Die einzelnen Messwerte der Messwert-Zeitreihe können erfindungsgemäß als zeitgemittelte Werte der elektrischen Leistung oder des elektrischen Energieverbrauchs der vermessenen Anzahl von Verbrauchsgeräten erfasst werden, wobei die Zeitmittelung bevorzugt über ein Zeitintervall mit einer Länge von einigen Minuten bis einigen 10 Minuten (z.B. 10 bis 15 min.) erfolgt. Bevorzugt werden die einzelnen Messwerte dabei zu mit konstanten Zeitabständen zeitlich aufeinanderfolgenden Zeitpunkten erfasst bzw. gemittelt.

Die vorliegende Erfindung bzw. das entsprechende Verfahren kann beispielsweise in Form eines Mikrocontrollers in einen handelsüblichen Strommesszähler integriert werden. Alternativ dazu ist es jedoch auch möglich, das vorliegende Verfahren im Rahmen eines Webservers zu verwirklichen. Ein Strommesszähler kann dann über ein Netzwerk, beispielsweise über das Internet, die erfassten Messwerte als besagte Messwert-Zeitreihe an den Webserver bzw. an einen anderen Ortes (beispielsweise bei einem Provider) angeordneten Server übertragen, der dann, durch ein geeignet gestaltetes Computerprogramm, eine entsprechende Auswertung vornimmt. Die vorliegende Erfindung kann somit auch in Form eines Computerprogramms auf einem Webserver eines Energieversorgers realisiert werden, es ist somit (außer z.B. einer drahtlosen Datenübertragungseinheit von der Messstelle an den Server) kein eigenständiges Gerät oder Bauteil notwendig.

Im Gegensatz zu den aus dem Stand der Technik bekannten Verfahren/Vorrichtungen hat die vorliegende Erfindung eine Reihe wesentlicher Vorteile:
- Das erfindungsgemäße Verfahren kann ohne größeren Installations- oder Messaufwand kostengünstig und schnell eingesetzt werden. Der Vorteil besteht dabei insbesondere darin, dass einem Energieversorger, Messdienstleister oder auch einem einzelnen Haushalt ein Mehr an Informationen zur Verfügung gestellt werden kann.
- Die Erfindung hilft somit einem Endkunden, seinen Verbrauch und dessen Struktur besser abzuschätzen und somit beispielsweise auch Strategien zum Energiesparen abzuleiten. Insbesondere liefert die Erfindung eine Abschätzung darüber, welche Geräteklassen im konkreten Fall welchen Energieverbrauch zeigen, so z.B. wie groß der Anteil der Großverbraucher (Herd, Waschmaschine usw.) an der verbrauchten Energie ist oder wie hoch der Energieverbrauch der im Standby-Betrieb arbeitenden Geräte ist.
- Der Einsatz der vorliegenden Erfindung ist dabei sowohl vom Datenvolumen als auch von der benötigten Rechnerleistung problemlos. Die Erfindung lässt sich dabei insbesondere bei fernauslesbaren Stromzählern einsetzen.

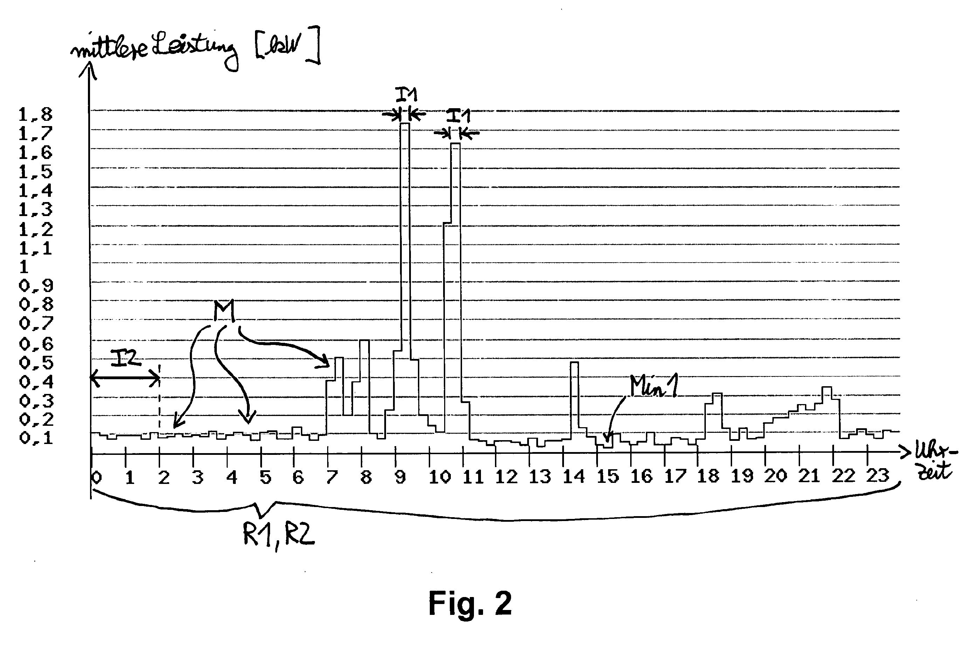

Nachfolgend wird die folgende Erfindung anhand eines detaillierten Ausführungsbeispiels mit den Figuren 2 bis 9 beschrieben.

Das beispielhaft geschilderte erfindungsgemäße Verfahren berechnet einen ersten elektrischen Verbrauchskennwert V1 zur Kennzeichnung von in elektrischer Bereitschaft stehenden, im Standby-Modus arbeitenden Verbrauchsgeräten der hinsichtlich ihres Energieverbrauchs erfassten Mehrzahl von Verbrauchsgeräten, indem zunächst eine erste Zeitintervalllänge I1 (vgl. Figur 2) definiert wird.

Beispielsweise beträgt diese erste Zeitintervalllänge I1 15 min., d.h. es werden einzelne Messwerte eines Haushalts-Stromzählers als Messstelle im 15-min.-Abstand erfasst bzw. über diese Zeitintervalle gemittelt. Die einzelnen Messwerte der auszuwertenden Messwert-Zeitreihe sind somit Mittelwerte des Gesamtenergieverbrauchs der betrachteten Verbrauchsgeräte über jeweils 15 min. Solche Messwerte mit der geschilderten zeitlichen Auflösung können ohne weiteres mit der heutigen Technik gemessen, übertragen und/oder gespeichert werden. Anstelle des mittleren Energieverbrauchs über 15 min. kann jeweils auch die mittlere Leistung über ein entsprechend langes Zeitintervall I1 erfasst werden.

Die Messwert-Zeitreihe M (Figur 2) besteht dann beispielsweise aus 24 x 4 = 96 einzelnen, über einen Tag erfassten (und jeweils über 15 Minuten gemittelten) Messwerten des Gesamtenergieverbrauchs. Die einzelnen Messwerte wurden in Fig. 2 in zeitlich konstanten Abständen ermittelt, wobei die Mittelwertbildung jeweils über 15 min. lange Intervalle I1, die sich jeweils zeitlich unmittelbar aneinander anschließen, erfolgte.

Die einzelnen Messwerte bzw. Mittelwerte über die Intervalle I1 wurden über einen vollen Tag ermittelt (erster Referenzzeitraum R1, siehe Figur 2).

Anschließend wurde aus der Menge der so erhaltenen 96 Mittelwerte über den Zeitraum R1 der kleinste Mittelwert (erster Minimalwert) ausgewählt und als der erste elektrische Verbrauchskennwert V1 verwendet. Alternativ dazu können auch die n kleinsten Minimalwerte (beispielsweise die fünf oder zehn kleinsten Minimalwerte) ausgewählt werden und aus diesen kann dann durch erneute Mittelwertbildung ein Wert berechnet werden, der dann als erster elektrischer Verbrauchskennwert V1 verwendet wird.

Beispielsweise beträgt der erster Minimalwert Min1, also derjenige Wert, der für die Abschätzung der Standby-Leistung verwendet wird, im in Figur 2 gezeigten Fall (im Intervall I1 zwischen 15:15 h und 15:30 h) etwa 25 Watt.

Im in Figur 2 gezeigten Fall wurden die einzelnen Intervalle I1 innerhalb des Referenzzeitraums R1 zeitlich unmittelbar aneinandergrenzend und nicht überlappend gewählt. Alternativ dazu können die einzelnen Intervalle I1 jedoch auch zeitlich überlappend ausgewählt bzw. ausgewertet werden (beispielsweise erstes Intervall I1 von 0:00 h bis 0:30 h, zweites Intervall I1 von 0:15 h bis 0:45 h, drittes Intervall I1 von 0:30 h bis 1:00 h, viertes Intervall I1 von 0:45 h bis 1:15 h usw.).

Grundsätzlich liefert das erfindungsgemäße Verfahren mit höherer zeitlicher Auflösung (d.h. geringerem Abstand zwischen den einzelnen Messzeitpunkten) bessere Ergebnisse.

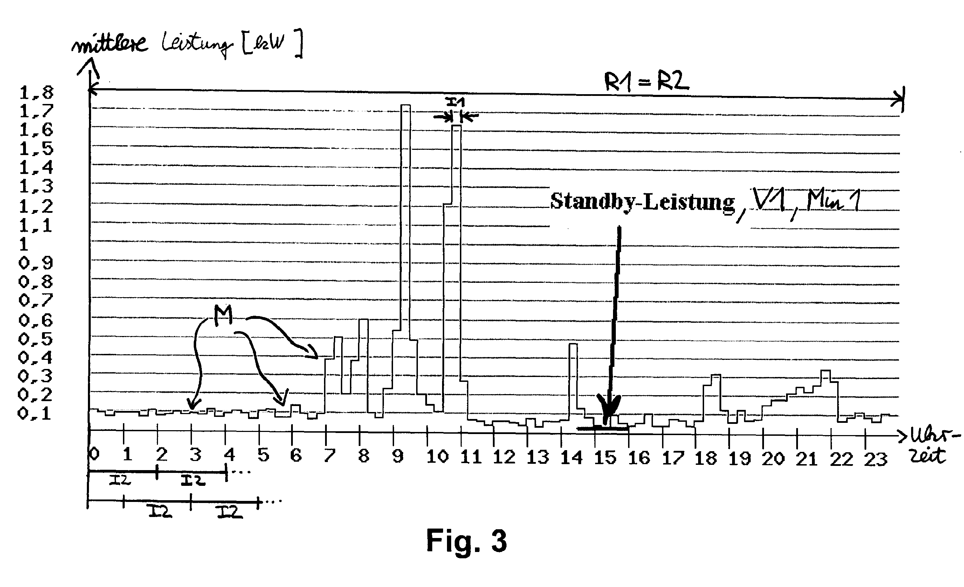

Erfindungsgemäß wird somit (im Rahmen eines ersten elektrischen Verbrauchskennwertes V1) die permanente Standby-Leistung der im Standby-Betrieb arbeitenden Verbrauchsgeräte der Gesamtzahl der betrachteten Verbrauchsgeräte auf Basis eines niedrigsten mittleren Leistungskennwertes (gemittelt über eine erste Intervalllänge I1) über einen Referenzzeitraum R1, der deutlich länger als die erste Intervalllänge I1 ist, ermittelt. Wenn das Messintervall (hier I1 = 15 min.) gering genug ist, berechnet, da irgendwann keine elektrischen Geräte mehr arbeiten, die nicht im Standby-Betrieb sind (z.B. nachts), das erfindungsgemäße Verfahren zuverlässig nur die Leistung der Standby-Geräte. So schalten sich beispielsweise Kühlgeräte immer nur kurz an und aus, so dass mit dem vorgestellten Verfahren mit sehr hoher Wahrscheinlichkeit ein Intervall erhalten wird, in dem gerade keine Kühlgeräte eingeschaltet sind. Der geschätzte Energieverbrauch der Standby-Geräte pro Stunde ergibt sich dann aus der so ermittelten Standby-Leistung bzw. dem ersten elektrischen Verbrauchskennwert V1 (siehe auch Figur 3). Der Referenzzeitraum R1, in dem der kleinste Wert gesucht wird, sollte in der Regel mindestens 24 h, besser jedoch einige Tage oder eine Woche lang sein.

Um Messfehler oder kurze Lastunterbrechungen unberücksichtigt zu lassen, kann in einer Variante der Erfindung auch nicht einfach der minimale Mittelwert Min1 im Referenzzeitraum R1 verwendet werden, sondern es können Mittelwerte mit dem Wert 0 kW ausgefiltert bzw. ignoriert werden (entsprechend können bei einer Auswahl der beispielsweise 5 oder 10 kleinsten Mittelwerte zur Bildung des Minimalwerts Min1 solche Werte unberücksichtigt bleiben). Ebenso kann beispielsweise auch eine untere Grenze von x % (beispielsweise 5 %) der Werte unberücksichtigt gelassen werden, dies hat dann den Effekt, dass kurze Unterbrechungen der Standby-Last (beispielsweise durch Stromausfall oder ähnliches) nicht mit berücksichtigt werden.

Mit dem für den ersten Verbrauchskennwert V1 beschriebenen Verfahren wird nahezu sicher ein Intervall erhalten, bei dem gerade keine taktenden Kühlgeräte oder ähnliches eingeschaltet waren und währenddessen auch keine sonstigen Großverbrauchergeräte, wie Waschmaschinen oder ähnliches, verwendet wurden.

Erfindungsgemäß kann (alternativ oder kumulativ zum ersten elektrischen Verbrauchskennwert V1) ein zweiter elektrischer Verbrauchskennwert V2 berechnet werden, der dann den Gesamtverbrauch aus in elektrischer Bereitschaft stehenden (im Standby-Modus arbeitenden) Verbrauchsgeräten und von sich selbständig an- und abschaltenden (getakteten) Verbrauchsgeräten kennzeichnet.

Die Vorgehensweise hierzu ist ebenfalls in den Figuren 2 und 3 erläutert: Ebenso wie über die ersten Zeitintervalllängen I1 eine Vielzahl einzelner gemittelter Messwerte ermittelt wird, wird für den zweiten Verbrauchskennwert V2 über eine zweite Intervalllänge I2, die größer als die erste Intervalllänge I1 ist, eine entsprechende Vielzahl von gemittelten Messwerten berechnet. Dies kann beispielsweise einfach dadurch geschehen, dass (vgl. beispielsweise Figur 3, links unten oder Figur 2, links) jeweils acht aufeinanderfolgende I1-Intervallmittelwerte zusammengefasst und erneut gemittelt werden. Wie Figur 3 links unten zeigt, können dabei die zweiten Zeitintervalle I2 zeitlich aufeinanderfolgend und nicht-überlappend gewählt werden (Figur 3, links, unterste Zeile) oder auch zeitlich versetzt zueinander und partiell überlappend (Figur 3, links unten, die beiden untersten Zeilen: zeitlicher Überlapp benachbarter zweiter Zeitintervalle I2 jeweils 50 % der Intervalllänge).

Die Länge des zweiten Referenzzeitraums R2, über den dann die Vielzahl von Mittelwerte über zweite Zeitintervalllängen I2 bestimmt wird, kann dabei dem ersten Referenzzeitraum R1 entsprechen.

Zur Berechnung des zweiten elektrischen Verbrauchskennwerts V2 kann dann wiederum aus der Menge der erhaltenen Mittelwerte über die Intervalle I2 der kleinste (oder der gemittelte Wert aus den fünf oder zehn kleinsten) ausgewählt werden.

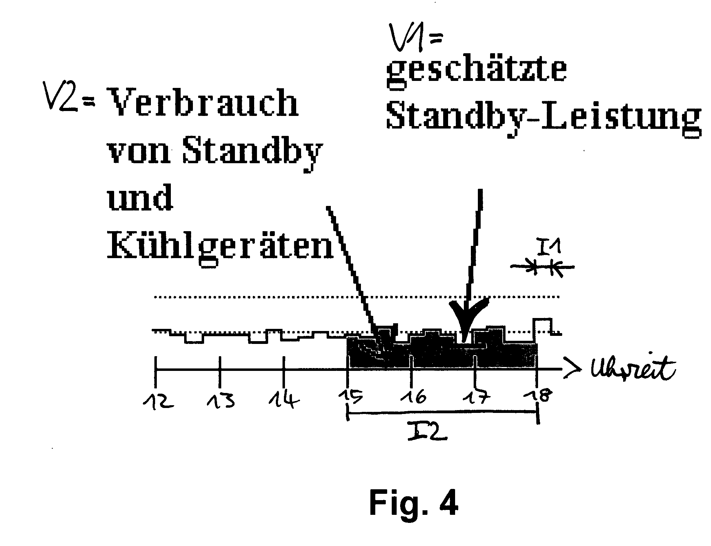

Figur 4 skizziert noch einmal die Berechnung des ersten elektrischen Verbrauchskennwertes V1 durch Mittelung und Auswahl über die Intervalllänge I1 und diejenige des zweiten elektrischen Verbrauchskennwertes V2 durch Mittelung und Auswahl über die zweite Zeitintervalllänge I2 (die in Figur 4 einer Länge von 12 x I1 entspricht).

Der Berechnung des zweiten elektrischen Verbrauchskennwertes V2 liegen somit die folgenden Überlegungen zugrunde: Insbesondere Kühlgeräte verbrauchen nicht permanent Strom, sondern schalten zyklisch an und wieder ab. Wenn die kleinste mittlere Leistung eines sehr kurzen Intervalls ausgewählt wird, sind die Kühlgeräte mit hoher Wahrscheinlichkeit darin ausgeschaltet (siehe vorstehend I1 bzw. V1). Wird dagegen der kleinste mittlere Verbrauch über einen längeren Zeitraum von beispielsweise 2 bis 3 h ermittelt, so ist darin mit hoher Wahrscheinlichkeit der Energieverbrauch der Kühlgeräte mit enthalten. Trotzdem kann davon ausgegangen werden, dass der kleinste mittlere Verbrauch über ein solches längeres Zeitintervall zu einem Zeitpunkt auftritt, bei dem keine sonstigen Geräte laufen (im Allgemeinen nachts). Dies zeigt Figur 4, in der ein Beispiel für einen Lastverlauf zu einem Zeitpunkt ausschnittsweise gezeigt ist, an dem die Bewohner eines Hauses inaktiv sind. Die minimale mittlere Leistung (horizontaler Strich in Figur 4) ist dabei eine Abschätzung für die Standby-Last. Der kleinste Verbrauch über ein längeres Intervall I2 (im Bild 4 3 h) ist dagegen eine Abschätzung für den Verbrauch aller Geräte, die regelmäßig Energie verbrauchen, d.h. der Standby-Geräte und taktender Geräte, wie beispielsweise Kühlgeräte.

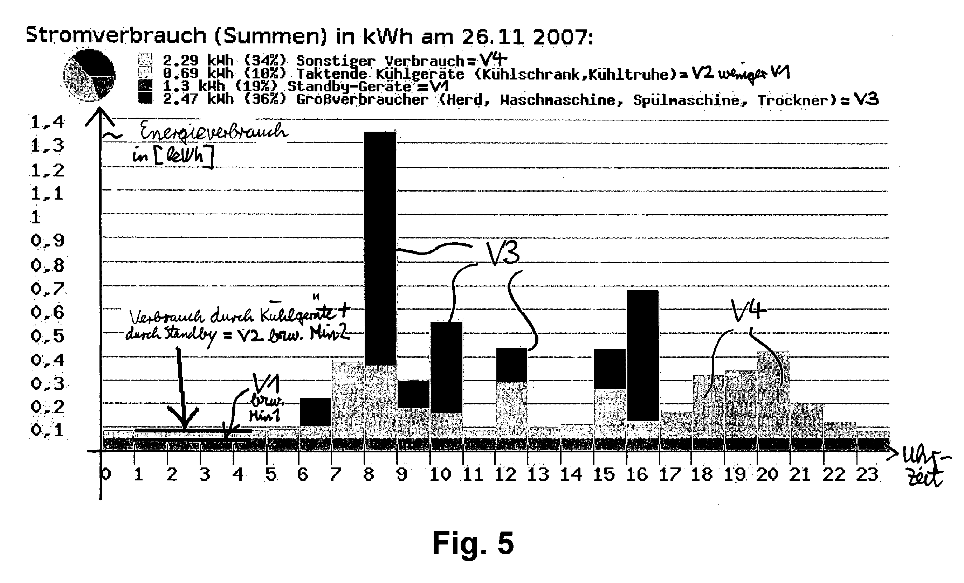

Somit erfasst die vorliegende Erfindung über den Verbrauchskennwert V2 den Energieverbrauch der Standby-Geräte und der taktenden Geräte (aus der Summe des Verbrauchs der taktenden Geräte und der Standby-Geräte kann dann der Energieverbrauch der taktenden Geräte alleine durch einfache Subtraktion des ersten elektrischen Verbrauchskennwertes V1 vom zweiten elektrischen Verbrauchskennwert V2 berechnet werden). Figur 5 zeigt diese Zusammenhänge links unten, zu den weiter berechneten elektrischen Verbrauchskennwerten V3 und V4 (siehe nachfolgend).

Der kleinste mittlere Verbrauch über ein längeres Zeitintervall kann somit aus der mittleren Leistung bzw. dem mittleren Verbrauch über I1-Intervalle einfach durch Mittelwertbildung über z.B. acht oder zwölf solcher I1-Intervalle berechnet werden, was dann nach Auswahl z.B. des kleinsten Werts Min2 den gesuchten kleinsten mittleren Verbrauch über das längere Zeitintervall I2 ergibt.

Der kleinste der vorkommenden I2-Werte kann also als Schätzwert für den zweiten elektrischen Verbrauchskennwert V2 (für den Verbrauch von taktenden Geräten und von Standby-Geräten) verwendet werden.

Wie für den ersten Verbrauchskennwert V1 geschildert, können auch für den zweiten Verbrauchskennwert V2, um z.B. Messfehler unberücksichtigt zu lassen, bei der Auswahl des Minimalwertes Min2 I2-Intervallmittelwerte der Höhe 0 ignoriert werden. Alternativ dazu können auch die untersten x % (beispielsweise 5 %) der Werte unberücksichtigt gelassen werden, damit auch kurze Unterbrechungen der Last (Stromausfall) nicht mit berücksichtigt werden.

Alternativ oder kumulativ zu den Verbrauchskennwerten V1 und V2 kann erfindungsgemäß ein dritter elektrischer Verbrauchskennwert V3 zur Kennzeichnung von elektrischen Großverbrauchern (wie beispielsweise Waschmaschinen, Spülmaschinen etc.), die üblicherweise aktiv von Benutzern ein- und ausgeschaltet werden, berechnet werden.

Eingangsgröße dieser Berechnung bildet wieder die Messwert-Zeitreihe M (Figur 2), die jetzt hinsichtlich ihrer ersten Ableitung bzw. ihres Differenzquotienten nach der Zeit (oder einer diese Größe annähernden Größe) numerisch ausgewertet wird.

So kann, sobald die erste Ableitung (bzw. die Steigung oder der Gradient der Messwert-Zeitreihe) einen ersten vorbestimmten positiven Wert W1 überschreitet, diese Überschreitung registriert und der entsprechende Zeitpunkt als eine erste Zeitgrenze t1, zu der ein (oder mehrere) Großverbraucher eingeschaltet wurde/wurden, festgelegt werden.

Das erfindungsgemäße Verfahren kann dann überprüfen, zu welchem Zeitpunkt nach der ersten Zeitgrenze t1 die erste Ableitung (oder die diese annähernde Größe) zeitlich gesehen erstmalig einen kleineren Wert als ein zweiter vorbestimmter negativer Wert W2 annimmt. Dieser Zeitpunkt der Unterschreitung des vorbestimmten negativen Wertes (der bevorzugt betragsmäßig gleich dem ersten Wert W1 gewählt werden kann) wird dann als zweite Zeitgrenze, zu der der oder die Großverbraucher wieder ausgeschaltet wurde(n), festgehalten.

Das erfindungsgemäße Verfahren sucht somit nach aufsteigenden Flanken der Messwert-Zeitreihe, die das Anschalten von Großverbrauchern charakterisieren und nach danach auftretenden abfallenden Flanken, die ein Wiederausschalten dieser Großverbraucher charakterisieren. Dabei kann das erfindungsgemäße Verfahren die Messwert-Zeitreihe wie vorbeschrieben nicht nur von früheren Zeitpunkten in Richtung auf spätere Zeitpunkte auswerten, sondern kann auch in umgekehrter Richtung durchgeführt werden (es werden dann zunächst die absteigenden Flanken, die das Ausschalten charakterisieren, aufgefunden, so dass danach nach einer zugehörigen aufsteigenden Flanke, die das zeitlich davor liegende Einschalten charakterisiert, gesucht wird). Aufgrund der numerischen Auswertungen können die beiden Richtungen leicht unterschiedliche Ergebnisse liefern; aus diesem Grunde kann auch eine Mittelung der Ergebnisse in beide Richtungen erfolgen.

Erfindungsgemäß wird dann ein vorbestimmter Anteil des elektrischen Gesamtverbrauchs der erfassten Menge von Gebrauchsgeräten in der so bestimmten Zeitspanne t2-t1 zwischen der ersten und der zweiten Zeitgrenze (oder ein davon abgeleiteter Wert) als der dritte elektrische Verbrauchskennwert verwendet. Wie dieser vorbestimmte Anteil des elektrischen Gesamtverbrauchs bestimmt werden kann, wird nachfolgend noch im Detail erläutert.

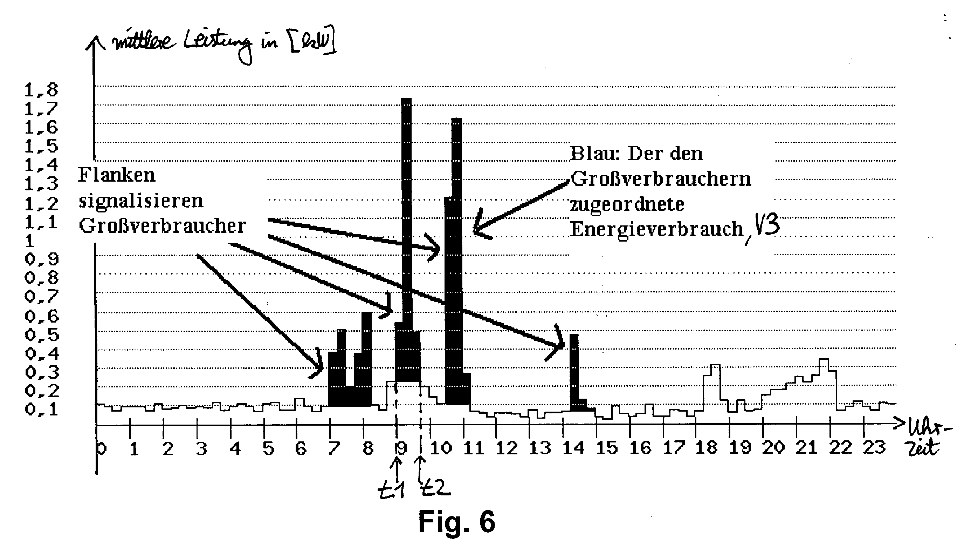

Der Energieverbrauch von Großverbrauchern (z.B. Herd, Trockner, Spülmaschine oder Waschmaschine) kann somit erfindungsgemäß dadurch abgeschätzt werden, das stark ansteigende Flanken als Einschaltvorgänge interpretiert und danach fallende Flanken als Ausschaltvorgänge interpretiert werden. Dadurch kann eine Abschätzung über die jeweilige Leistung der Großverbraucher erfolgen, so dass (beispielsweise durch Integration zwischen den Zeitgrenzen t1 und t2) der Verbrauch der Großgeräte berechnet werden kann (vgl. auch Figur 6).

Numerisch können stark ansteigende Flanken eines größeren Verbrauchers beispielsweise dadurch erkannt werden, dass eine mittlere Leistung über ein I1-Messintervall größer ist, als die mittlere Leistung über das zeitlich davor liegende I1-Intervall plus eine vordefinierte Konstante K: Wenn also P₂ > P₁ + K gilt (P₂ mittlere Leistung im späteren I1-Intervall, P₁ mittlere Leistung im früheren I1-Intervall und K vordefinierte Konstante), dann ist eine ansteigende Flanke erkannt. Beispielsweise kann K = 500 W gewählt werden. Kleinere Schwankungen werden somit nicht den Großverbrauchern zugeordnet.

Beispiel:
0:00 h bis 0:15 h: P = 200 W
0:15 h bis 0:30 h: P = 150 W
0:30 h bis 0:45 h: P = 750 W

Somit ergibt sich im dritten Intervall I1 des Tages eine ansteigende Flanke um 600 W, die Großverbrauchern zugeordnet wird, da der Wert um mehr als 500 W über dem vorherigen liegt.

Es gibt nun verschiedene Möglichkeiten, wieviel Last (nach dem Feststellen einer ansteigenden Flanke) im Weiteren den Großverbrauchern zugerechnet wird.

Beispielsweise kann in einer ersten Variante dieser dann dem dritten elektrischen Verbrauchskennwert V3 zuzuordnende, vorbestimmte Anteil des elektrischen Gesamtverbrauchs aller Last über dem Verbrauchswert vor der Flanke (im Beispiel 150 W) entsprechen (es wird also jegliche Leistung über einem Wert von 150 W als Großverbraucherleistung dem Verbrauchskennwert V3 zugeordnet, bis die Leistung wieder auf den Wert vor der Flanke, also die 150 W, gefallen ist. Eine solche Schätzung ist jedoch vergleichsweise grob.

Alternativ dazu kann das erfindungsgemäße Verfahren, das ja im Beispiel ab 0:30 h insgesamt 600 W (entsprechend dem Anstieg 750 W - 150 W) den Großverbrauchern zuordnet, im weiteren auch die zum Zeitpunkt der aufsteigenden Flanke bestimmte Großverbraucherlast (also genau die 600 W im Beispiel) den Großverbrauchern zuordnen, bis die Last wieder abfällt, wobei die sinkende Last entsprechend vom Anteil der Großverbraucher abgezogen wird: Mit anderen Worten kann somit die Differenz zweier benachbarter I1-Intervallwerte (eines ersten Messwertes eines I1-Intervalls vor dem Flankenzeitpunkt und eines zweiten Messwertes des unmittelbar darauf folgenden I1-Intervalls nach dem Flankenzeitpunkt) gebildet werden, die derartig bestimmte Differenz als klassifizierte Großverbraucherlast definiert werden und dieser so bestimmte Wert unabhängig von den in den dann darauf folgenden I1-Intervallen auftretenden Messwerten der Messwert-Zeitreihe M solange als Großverbraucherlast zur Berechnung des dritten elektrischen Verbrauchskennwertes V3 verwendet werden, bis die Last erstmals wieder unter einen vordefinierten Wert sinkt.

Beispiel:
0:00 h bis 0:15 h: P = 200 W
0:15 h bis 0:30 h: P = 150 W
0:30 h bis 0:45 h: P = 750 W (somit ansteigende Großverbraucher-Flanke von 600 W, da der Wert um mehr als 500 W über dem vorherigen Wert liegt)
0:45 h bis 1:00 h: 850 W (davon dann entsprechend der vorher bestimmten Differenz 600 W für Großverbraucher)
1:00 h bis 1:15 h: 500 W (davon dann noch 250 W für die Großverbraucher: Der Lastabfall um 850 - 500 = 350 W wird vom Großverbraucher-Anteil von 600 W abgezogen, so dass in diesem fünften I1-Intervall noch 250 W als Großverbraucheranteil ausgewiesen werden bzw. in den dritten Verbrauchskennwert V3 eingehen).
1:15 h bis 1:30 h: P = 200 W (keine Großverbraucher mehr, da erneuter Abfall um 300 W größer als der noch verbleibende Großverbraucheranteil von 250 W).

Die Bestimmung des dritten elektrischen Verbrauchskennwerts V3 kann erfindungsgemäß dahingehend variiert werden, ab welchem Lastanstieg ein Großverbraucher vermutet wird und wie das Ausschalten registriert wird. Im vorbeschriebenen Beispiel wird das Ausschalten dadurch registriert, dass der Lastwert unmittelbar vor dem Einschaltvorgang wieder erreicht wird. Wenn also bei einer momentanen Leistung von 100 W ein Einschaltvorgang (steil ansteigende Flanke im Verbrauch) registriert wird, wird im weiteren Verlauf (vorstehende erste Variante) die Leistung über 100 W der Kategorie Großverbraucher zugeordnet, bis die Leistung wieder auf 100 W abfällt. In der zweiten Variante wird stattdessen nur der Lastanstieg zum Zeitpunkt der ansteigenden Flanke den Großverbrauchern zugeordnet.

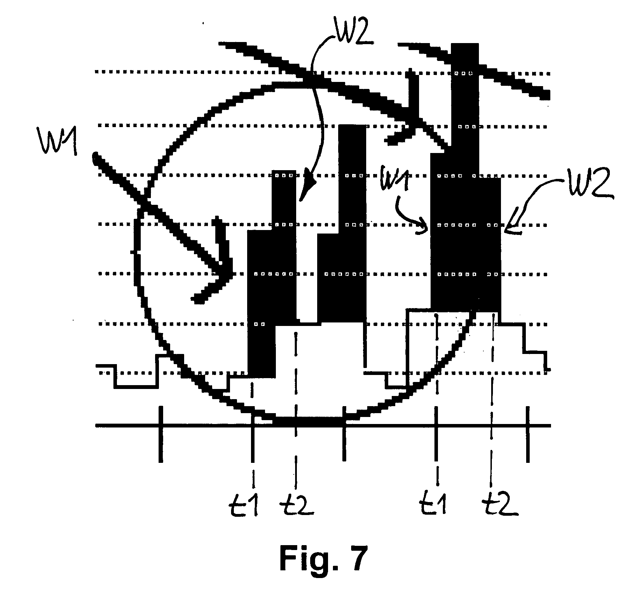

Wie Figuren 6 und 7 zeigen, können im Rahmen der Referenzzeiträume R1 bzw. R2 (über die auch die Bestimmung des dritten Verbrauchskennwertes V3 erfolgen kann) auch mehrere Großverbraucher-Zeitspannen t2-t1 auftreten, die jeweils durch das Überschreiten eines vorbestimmten Positivwertes W1 und das darauf folgende erste Unterschreiten des Negativwertes W2 identifiziert werden.

Wie vorbeschrieben kann als Variante die Erkennung auch in umgekehrter zeitlicher Richtung durchgeführt werden, indem von hinten nach vorne fallende Flanken als Ausschaltvorgänge von Großverbrauchern identifiziert werden, denen dann die zeitlich davor stattfindenden Einschaltvorgänge zugeordnet werden müssen. Das Verfahren kann auch in beiden Zeitrichtungen durchgeführt werden; die Ergebnisse sind dann zu mitteln. All diese Varianten haben dabei gemeinsam, dass Flanken im Lastverlauf erkannt und bewertet werden.

Der Energieverbrauch, der vom Gesamtenergieverbrauch durch die ersten bis dritten Verbrauchskennwerte V1 bis V3 nicht der Standby-Leistung, den taktenden Verbrauchsgeräten oder den Großverbrauchern zugeordnet werden kann, wird im Rahmen eines vierten Verbrauchskennwertes V4 den sonstigen Verbrauchern zugeordnet.

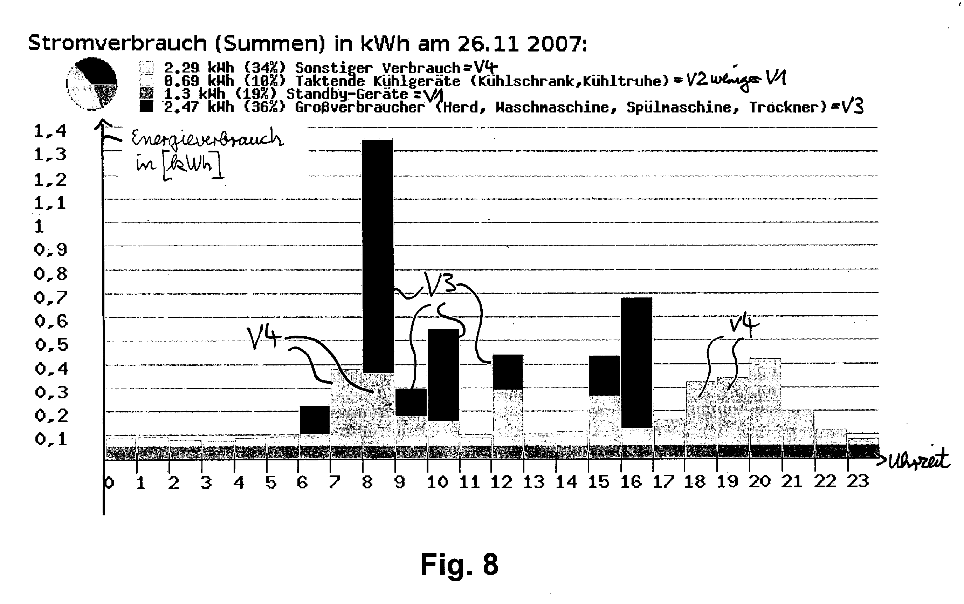

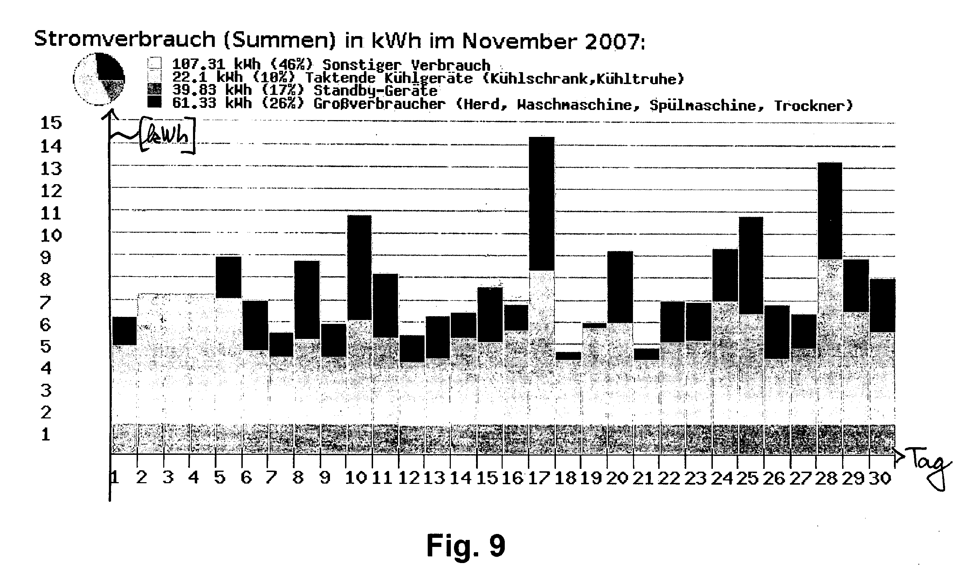

Im Ergebnis zeigt Figur 8 eine durch Berechnung von Verbrauchskennwerten V1 bis V4 wie vorbeschrieben ermittelte Aufschlüsselung des elektrischen Verbrauchs einer Mehrzahl von elektrischen Verbrauchsgeräten. Als Ergebnis ergibt sich somit eine Aufteilung des Energieverbrauchs in verschiedene Verbraucherklassen, die dann, sofern gewünscht, auch als Tages- oder als Monatsübersicht weiter aufbereitet werden kann (vgl. Figur 9).

Selbstverständlich sind auch weitere Aufbereitungsformen in Form von z.B. Jahresübersichten oder anderen Statistiken denkbar.

## Patentansprüche

1. Verfahren zur Aufschlüsselung des elektrischen Verbrauchs einer Mehrzahl von elektrischen Verbrauchsgeräten,
wobei mittels einer Messstelle der elektrische Gesamtverbrauch dieser Mehrzahl von Verbrauchsgeräten als Messwert-Zeitreihe (M) zeitaufgelöst erfasst wird, und
wobei unter Verwendung dieser zeitaufgelöst erfassten Messwert-Zeitreihe jeweils mindestens ein elektrischer Verbrauchskennwert (V1, V2, ...) für mehrere unterschiedliche elektrische Verbrauchsklassen der Verbrauchsgeräte dieser Mehrzahl von Verbrauchsgeräten berechnet wird, bevorzugt computergestützt berechnet wird.

2. Verfahren nach dem vorhergehenden Anspruch,
***dadurch gekennzeichnet, dass***
die mehreren elektrischen Verbrauchskennwerte unter Verwendung ausschließlich der zeitaufgelöst erfassten Messwert-Zeitreihe berechnet werden.

3. Verfahren nach einem der vorhergehenden Ansprüche,
***dadurch gekennzeichnet, dass***
ein erster elektrischer Verbrauchskennwert (V1) zur Kennzeichnung von in elektrischer Bereitschaft stehenden, also im Standby-Modus arbeitenden Verbrauchsgeräten der Mehrzahl von Verbrauchsgeräten berechnet wird, indem eine erste Zeitintervalllänge (I1) definiert wird, indem zu verschiedenen Zeitpunkten innerhalb eines ersten Referenzzeitraums (R1), der größer als die erste Zeitintervalllänge ist, aus oder auf Basis der Messwert-Zeitreihe (M) jeweils ein Mittelwert für den elektrischen Gesamtverbrauch der Mehrzahl von Verbrauchsgeräten über ein Zeitintervall mit der ersten Zeitintervalllänge berechnet wird, und indem aus der Menge der so erhaltenen Mittelwerte ein erster Minimalwert (Min1) bestimmt und als der erste elektrische Verbrauchskennwert (V1) verwendet wird.

4. Verfahren nach dem vorhergehenden Anspruch,
***dadurch gekennzeichnet, dass***
der erste Minimalwert (Min1) durch Auswahl des kleinsten Wertes aus der Menge der so erhaltenen Mittelwerte bestimmt wird
oder
dass der erste Minimalwert (Min1) durch Auswahl der n kleinsten Werte (mit n=1, 2, 3, ... , 10) aus der Menge der so erhaltenen Mittelwerte und durch erneute Mittelwertbildung über diese Auswahl bestimmt wird.

5. Verfahren nach einem der beiden vorhergehenden Ansprüche,
***dadurch gekennzeichnet, dass***
der erste Referenzzeitraum (R1) mindestens 10, bevorzugt mindestens 50, bevorzugt mindestens 100, bevorzugt mindestens 250 mal so groß, also so lang ist, wie die erste Zeitintervalllänge (I1),
und/oder
dass der erste Referenzzeitraum (R1) eine Länge von ≥ 6 Stunden, bevorzugt von ≥ 12 Stunden, bevorzugt von ≥ 24 Stunden, bevorzugt von ≥ 5 Tagen aufweist
und/oder
dass die erste Zeitintervalllänge (I1) ≥ 0.5 Minuten und ≤ 1 Stunde, bevorzugt ≥ 3 Minuten und ≤ 30 Minuten, bevorzugt ≥ 5 Minuten und ≤ 20 Minuten, bevorzugt ≥ 10 Minuten und ≤ 15 Minuten ist
und/oder
dass die verschiedenen Zeitpunkte, die Länge des ersten Referenzzeitraums (R1) und die erste Zeitintervalllänge (I1) so ausgewählt werden, dass jeweils über mehrere unmittelbar aneinander angrenzende Zeitintervalle mit der ersten Zeitintervalllänge oder jeweils über mehrere zeitlich versetzt zueinander angeordnete, sich teilweise zeitlich überlappende Zeitintervalle mit der ersten Zeitintervalllänge Mittelwerte für den elektrischen Gesamtverbrauch der Mehrzahl von Verbrauchsgeräten berechnet werden.

6. Verfahren nach einem der vorhergehenden Ansprüche,
***dadurch gekennzeichnet, dass***
ein zweiter elektrischer Verbrauchskennwert (V2) zur Kennzeichnung von in elektrischer Bereitschaft stehenden, also im Standby-Modus arbeitenden Verbrauchsgeräten und von sich selbstständig an- und abschaltenden, bevorzugt sich zyklisch an- und abschaltenden Verbrauchsgeräten der Mehrzahl von Verbrauchsgeräten berechnet wird, indem eine zweite Zeitintervalllänge (I2) definiert wird, indem zu verschiedenen Zeitpunkten innerhalb eines zweiten Referenzzeitraums (R2), der größer als die zweite Zeitintervalllänge ist, aus oder auf Basis der Messwert-Zeitreihe (M) jeweils ein Mittelwert für den elektrischen Gesamtverbrauch der Mehrzahl von Verbrauchsgeräten über ein Zeitintervall mit der zweiten Zeitintervalllänge berechnet wird, und indem aus der Menge der so erhaltenen Mittelwerte ein zweiter Minimalwert (Min2) bestimmt und als der zweite elektrische Verbrauchskennwert (V2) verwendet wird.

7. Verfahren nach dem vorhergehenden Anspruch, ***dadurch gekennzeichnet, dass***
der zweite Minimalwert (Min2) durch Auswahl des kleinsten Wertes aus der Menge der so erhaltenen Mittelwerte bestimmt wird
oder
dass der zweite Minimalwert (Min2) durch Auswahl der n kleinsten Werte (mit n=1, 2, 3, ... , 10) aus der Menge der so erhaltenen Mittelwerte und durch erneute Mittelwertbildung über diese Auswahl bestimmt wird.

8. Verfahren nach einem der beiden vorhergehenden Ansprüche,
***dadurch gekennzeichnet, dass***
der zweite Referenzzeitraum (R2) mindestens 5, bevorzugt mindestens 10, bevorzugt mindestens 20, bevorzugt mindestens 50 mal so groß, also so lang ist, wie die zweite Zeitintervalllänge (I2),
und/oder
dass der zweite Referenzzeitraum (R2) eine Länge von ≥ 12 Stunden, bevorzugt von ≥ 24 Stunden, bevorzugt von ≥ 5 Tagen aufweist und/oder
dass die zweite Zeitintervalllänge (I2) ≥ 0.5 Stunden und ≤ 12 Stunden, bevorzugt ≥ 1 Stunde und ≤ 4 Stunden, bevorzugt ≥ 2 Stunden und ≤ 3 Stunden ist
und/oder
dass die verschiedenen Zeitpunkte, die Länge des zweiten Referenzzeitraums (R2) und die zweite Zeitintervalllänge (I2) so ausgewählt werden, dass jeweils über mehrere unmittelbar aneinander angrenzende Zeitintervalle mit der zweiten Zeitintervalllänge oder jeweils über mehrere zeitlich versetzt zueinander angeordnete, sich teilweise zeitlich überlappende Zeitintervalle mit der zweiten Zeitintervalllänge Mittelwerte für den elektrischen Gesamtverbrauch der Mehrzahl von Verbrauchsgeräten berechnet werden.

9. Verfahren nach einem der sechs vorhergehenden Ansprüche,
***dadurch gekennzeichnet, dass***
die zweite Zeitintervalllänge (I2) größer oder gleich der ersten Zeitintervalllänge (I1) ist, wobei die zweite Zeitintervalllänge (I2) bevorzugt mindestens drei, bevorzugt mindestens fünf, bevorzugt mindestens zehn mal so groß ist wie die erste Zeitintervalllänge (I1)
und/oder
dass der zweite Referenzzeitraum (R2) so lang gewählt ist wie der erste Referenzzeitraum (R1).

10. Verfahren nach einem der vorhergehenden Ansprüche,
***dadurch gekennzeichnet, dass***
ein dritter elektrischer Verbrauchskennwert (V3) zur Kennzeichnung von elektrischen Großverbrauchsgeräten der Mehrzahl von Verbrauchsgeräten berechnet wird, indem die erste Ableitung der zeitaufgelöst erfassten Messwert-Zeitreihe (M) nach der Zeit oder eine diese erste Ableitung annähernde Größe berechnet wird, indem, wenn die ersten Ableitung oder die diese annähernde Größe einen ersten vorbestimmten positiven Wert (W1) überschreitet, dieser Überschreitungszeitpunkt als eine erste Zeitgrenze (t1) definiert wird, indem als zweite Zeitgrenze (t2) derjenige Zeitpunkt definiert wird, an dem die erste Ableitung oder die diese annähernde Größe zeitlich erstmalig nach der ersten Zeitgrenze einen kleineren Wert als ein zweiter vorbestimmter negativer Wert (W2), der bevorzugt betragsmäßig gleich dem ersten Wert (W1) gesetzt wird, annimmt, und indem ein vorbestimmter Anteil des elektrischen Gesamtverbrauchs der Mehrzahl von Verbrauchsgeräten in der Zeitspanne (t2-t1) zwischen der ersten und der zweiten Zeitgrenze oder ein davon abgeleiteter Wert als der dritte elektrische Verbrauchskennwert (V3) verwendet wird.

11. Verfahren nach dem vorhergehenden Anspruch, ***dadurch gekennzeichnet, dass***
die Messwert-Zeitreihe nicht wie im vorhergehenden Anspruch von früheren hin zu späteren Zeitpunkten zur Auswertung durchlaufen wird, sondern in umgekehrter Richtung, dass also ein Unterschreiten eines vorbestimmten negativen Werts und ein darauf folgendes, zeitlich erstmaliges Überschreiten eines vorbestimmten positiven Werts, der bevorzugt betragsmäßig dem negativen Wert entspricht, zur Festlegung der Grenzen der Zeitspanne verwendet wird,
oder
dass die Messwert-Zeitreihe zur Auswertung wie in diesem Anspruch beschrieben von späteren hin zu früheren Zeitpunkten durchlaufen wird und zusätzlich wie im vorhergehenden Anspruch beschrieben von früheren hin zu späteren Zeitpunkten durchlaufen wird, wobei der Mittelwert der beiden so erhaltenen vorbestimmten Anteile als der dritte elektrische Verbrauchskennwert (V3) verwendet wird
und/oder
dass der vorbestimmte Anteil des elektrischen Gesamtverbrauchs auf Basis des Gesamtverbrauchs in der Zeitspanne zwischen der ersten und der zweiten Zeitgrenze (t2-t1) abzüglich eines dem Gesamtverbrauch vor und/oder nach dieser Zeitspanne entsprechenden Verbrauchswertes für diese Zeitspanne oder auf Basis einer Differenz zwischen dem elektrischen Gesamtverbrauch nach und demjenigen vor der ersten Zeitgrenze (t1) und/oder zwischen dem elektrischen Gesamtverbrauch vor und demjenigen nach der zweiten Zeitgrenze (t2) berechnet wird.

12. Verfahren nach einem der vorhergehenden Ansprüche,
***dadurch gekennzeichnet, dass***
der erste (V1), der zweite und der dritte Verbrauchskennwert (V3) aus oder auf Basis der Messwert-Zeitreihe (M) berechnet werden, wobei bevorzugt der mit diesen drei Verbrauchskennwerten nicht erfasste Anteil am elektrischen Gesamtverbrauch der Mehrzahl von Verbrauchsgeräten einem vierten, zur Kennzeichnung von noch nicht erfassten Verbrauchsgeräten dienenden Verbrauchskennwert (V4) zugewiesen wird.

13. Verfahren nach einem der vorhergehenden Ansprüche,
***dadurch gekennzeichnet, dass***
als Messwerte der Messwert-Zeitreihe (M) zeitgemittelte Werte der elektrischen Leistung oder des elektrischen Energieverbrauchs der Mehrzahl von Verbrauchsgeräten verwendet werden, wobei die Zeitmittelung bevorzugt über ein Zeitintervall, dessen Länge der ersten Zeitintervalllänge (I1) entspricht, erfolgt,
und/oder
dass die einzelnen Messwerte der Messwerte-Zeitreihe mittels eines Stromzählers als Messstelle erfasst werden.
und/oder
dass die Messwerte der Messwert-Zeitreihe (M) zu mit konstanten Zeitabständen zeitlich aufeinander folgenden Zeitpunkten zeitaufgelöst erfasst werden.

14. Computergestützte Vorrichtung, insbesondere Rechnersystem, zur Aufschlüsselung des elektrischen Verbrauchs einer Mehrzahl von elektrischen Verbrauchsgeräten
***dadurch gekennzeichnet, dass***
die Vorrichtung zur Durchführung eines Verfahrens nach einem der vorhergehenden Verfahrensansprüche ausgebildet ist, wobei bevorzugt die berechneten elektrischen Verbrauchskennwerte auf einer Webseite darstellbar sind.

15. Computergestützte Vorrichtung nach dem vorhergehenden Anspruch,
***dadurch gekennzeichnet, dass***
die Vorrichtung als Messstelle zur Erfassung der Messwerte der Messwert-Zeitreihe einen Stromzähler umfasst oder dass die Vorrichtung als Teil eines Stromzählers ausgebildet ist
und/oder
dass die Vorrichtung ein netzwerkfähiges Rechnersystem umfasst, an das mittels einer externen Messstelle, insbesondere eines Stromzählers, erfasste Messwerte als die Messwert-Zeitreihe über ein Netzwerk, insbesondere das Internet, übertragbar sind und mit dem die Berechnungen des Verfahrens nach einem der vorhergehenden Verfahrensansprüche durchführbar sind.
